# EUROPÄISCHE PATENTSCHRIFT

(11) **EP 1 126 284 B1**
(45) Veröffentlichungstag und Bekanntmachung des Hinweises auf die Patenterteilung: **27.06.2007**
(21) Anmeldenummer: 00127797.9
(22) Anmeldetag: 19.12.2000
(51) Int. Cl.: G01R 33/34, G01R 33/31

(54) **Gekühlter NMR-Probenkopf mit gleichmässiger Temperierung der Messprobe**
Cooled NMR sample head with uniform temperature equalization of the test sample
Tête support d'échantillon pour la RMN avec équilibrage uniforme de la température de l'échantillon

(30) Priorität: 12.02.2000 DE 10006323
(43) Veröffentlichungstag der Anmeldung: 22.08.2001
(73) Patentinhaber: Bruker BioSpin AG, 8117 Fällanden (CH)
(72) Erfinder: Marek, Daniel, 5103 Möriken (CH)
(74) Vertreter: Kohler Schmid Möbus

(56) Entgegenhaltungen:
- US-A- 3 764 892
- US-A- 5 258 710
- MARESCH G G ET AL: "HIGH-TEMPERATURE NMR USING INDUCTIVE HEATING" REVIEW OF SCIENTIFIC INSTRUMENTS, AMERICAN INSTITUTE OF PHYSICS. NEW YORK, US, Bd. 61, Nr. 1, PART 1, 1990, Seiten 77-80, XP000101214 ISSN: 0034-6748
- BODEN N ET AL: "SAMPLE CELL FOR HIGH-PRECISION TEMPERATURE-DEPENDENCE NMR EXPERIMENTS" JOURNAL OF MAGNETIC RESONANCE, ACADEMIC PRESS, ORLANDO, FL, US, Bd. 98, Nr. 1, 1. Juni 1992 (1992-06-01), Seiten 92-108, XP000275048 ISSN: 1090-7807
- STYLES G A ET AL: "A furnace to reach 1100 degrees C in NMR cross coil probes" JOURNAL OF PHYSICS E (SCIENTIFIC INSTRUMENTS), MARCH 1976, UK, Bd. 9, Nr. 3, Seiten 223-225, XP001157434 ISSN: 0022-3735
- BARJAT H ET AL: "ADAPTATION OF COMMERCIAL 500 MHZ PROBES FOR LCNMR" JOURNAL OF MAGNETIC RESONANCE. SERIES A, ACADEMIC PRESS, ORLANDO, FL, US, Bd. 119, Nr. 1, 1. März 1996 (1996-03-01), Seiten 115-119, XP000559746 ISSN: 1064-1858

## Beschreibung

Die Erfindung betrifft eine NMR(= Kemspinresonanz)-Probenkopf vorrichtung nach dem Oberbegriff des Patentanspruchs 1.

Ein solcher gekühlter NMR-Probenkopf ist beispielsweise bekannt aus der US-A 5,247,256.

Der Probenkopf wird in einem Magneten zum Erzeugen eines hochgradig homogenen, statischen B₀ -Feldes eingebaut und enthält um eine z-Achse angeordnete HF-Empfangsspulen, welche mittels geeigneter Wärmetauscher und Wärmeleitungselemente im Betrieb bis auf Temperaturen von ca. 10 - 25 K abgekühlt werden, um bei der Messung das Signal-zu-Rausch-Verhältnis des empfangenen NMR-Signals zu verbessern. Die HF-Empfangsspulen befinden sich zum Zwecke der Wärmeisolation in einem evakuierten Raum, der im wesentlichen durch ein in der Regel metallisches Gehäuse des Probenkopfes gebildet wird, welches von einem um die z-Achse zylindrisch angeordneten Raumtemperaturrohr zur Aufnahme eines Probenröhrchens durchbrochen ist. Damit die HF-Signale von der Probe zu den HF-Empfangsspulen gelangen können, ist im axialen Bereich der Spulen das ansonsten normalerweise metallische Raumtemperaturrohr durch ein HF-durchlässiges Innenrohr, meist ein Glasrohr ersetzt, welches vakuumdicht an die metallischen Teile des Raumtemperaturrohres anschließt.

Zur Temperierung der Probensubstanz wird das Probenrohr nach dem Einführen in das Raumtemperaturrohr von unten her mittels eines warmen Luftstroms durch das Raumtemperaturrohr im wesentlichen auf einer gewünschten Temperatur (meist ca. 300 K) gehalten. Dabei tritt jedoch das Problem auf, daß die Meßprobe die ganz erheblich kühlere Umgebung des auf 10 - 25 K gekühlten NMR-Resonators "sieht" und dorthin ihre Wärme in radialer Richtung abstrahlt. Diese abgehende Wärme muß kontinuierlich vom aufsteigenden warmen Temperier-Luftstrom wieder zugeführt werden, damit die Meßprobe im wesentlichen auf der gewünschten Temperatur bleibt. Dieser Vorgang hat nun zur Folge, daß in der Meßprobe ein axialer und radialer Temperaturgradient entsteht, der die NMR-Messung stark stört.

Aufgabe der vorliegenden Erfindung ist es daher, einen gekühlten NMR-Probenkopf mit den eingangs genannten Merkmalen vorzustellen, bei dem die Temperaturgradienten in z-Richtung sowie in x-y-Richtung im Betrieb wesentlich verringert sind, ohne daß die NMR-Messung dabei beeinträchtigt wird.

Erfindungsgemäß wird diese Aufgabe durch die Merkmale des Patentanspruchs 1 gelöst.

Zu den erfindungsgemäßen NMR-Probenköpfen zählen neben denjenigen mit auswechselbaren Probenröhrchen auch sogenannte Durchflußköpfe, bei denen das Probenröhrchen fix eingebaut bleibt und die zu untersuchende Flüssigkeit durch eine dünne Leitung auf der einen Seite (unten) eingelassen wird und auf der anderen Seite (oben) hinausgeführt wird. Solche Probenköpfe können sowohl im kontinuierlichen Durchfluß wie auch im Flow- und Stop-Betrieb (für eine verlängerte Meßperiode) verwendet werden. Diese Probenköpfe werden einerseits für eine schnelle Sample-Einführung gebraucht, andererseits auch als eine sehr aussagekräftige Analysestufe, die einer Flüssig-Chromatographie Trennzelle nachgeschaltet wird. Im ersteren Fall spricht man von Durchflußprobenköpfen, im zweiten von LC-NMR Kopplung. Solche Probenköpfe werden auch als LC-Köpfe bezeichnet (Liquid Chromatography, im speziellen auch HPLC (High Pressure Liquid Chromatography). Derartige Probenköpfe können in besonderem Maße von der Kryo-Technologie und mithin von den erfindungsgemäßen Modifikationen profitieren.

Damit wird eine Wärmeableitung aus der Meßprobe und somit eine ungleichmäßige Abkühlung verhindert, ohne daß die empfangenen NMR-Signale wesentlich beeinträchtigt werden. Der Vorteil einer derartigen Temperiereinrichtung gegenüber dem bekannten Einsatz eines geheizten Luftstromes für das Probenröhrchen liegt vor allem darin, daß die Heizleistung gleichmäßig über die gesamte axiale Länge des Probenröhrchens erfolgen kann. Der mittlere Bereich wird damit ebenso gut temperiert wie die Randbereiche. Auf diese Weise können axiale Temperaturgradienten wirksam verhindert werden.

Ein herkömmlicher geheizter Luftstrom ohne die erfindungsgemäße Heizeinrichtung tritt normalerweise am unteren Ende des Probenröhrchens in das Raumtemperaturrohr ein, gibt von da an seine Wärme an das Probenröhrchen ab und kühlt sich dabei beim Aufsteigen in axialer Richtung immer weiter ab. Die Temperatur des geheizten Luftstroms im oberen Bereich des Probenröhrchens wird deshalb immer kleiner sein als die im unteren Bereich, wodurch sich zwangsläufig die Temperierleistung im oberen Bereich des Probenröhrchens verringert. Als Folge daraus entsteht immer ein axialer Temperaturgradient, der sich durch Vergrößerung der Luftmenge pro Zeiteinheit zwar etwas verringern läßt, jedoch prinzipiell nicht verhindert werden kann. Außerdem sind den entsprechenden Gegenmaßnahmen enge Grenzen gesetzt, da bei einer zu großen Luftmenge pro Zeiteinheit eine vibrationsfreie Lage oder saubere Rotation des Probenröhrchens nicht mehr gewährleistet werden kann.

Durch die entsprechende Auswahl der Temperiereinrichtung hinsichtlich ihres Absorptionsverhaltens von HF-Feldern wird eine nahezu vollständige Transparenz für die HF-Felder angestrebt, damit das Meßsignal möglichst unbeeinträchtigt von der Probe zum HF-Empfangsspulensystem gelangen kann.

Die Temperiereinrichtung im erfindungsgemäßen NMR-Probenkopf erfolgt durch eine Heizung mit elektrischem Strom.

Erfindungsgemäß umfaßt die Temperiereinrichtung eine oder mehrere Heizschlaufen aus dünnem, insbesondere schichtförmigem, elektrisch gut leitfähigem Material, die jeweils einen Hin- und einen Rückleiter aufweisen, wobei die Hin- und Rückleiter der Heizschlaufen jeweils einenends elektrisch miteinander verbunden sind und anderenends mit Heizstrom aus einer Stromquelle beschickt werden können.

Eine bevorzugte Ausführungsform zeichnet sich dadurch aus, daß die Heizschlaufen aus einer elektrisch leitfähigen Schicht aufgebaut sind, die das Probenröhrchen im axialen Bereich des HF-Empfangsspulensystems in der in Anspruch 1 definierten Weise, umgibt, eine radiale Dicke < 1 mm, vorzugsweise < 50µm aufweist und für Strahlung in einem Wellenlängenbereich λ > 100mm transparent ist. Insbesondere kann diese Schicht strahlungsabsorbierend sein, so dass eine Beheizung auf zwei verschiedene Arten möglich ist.

Besonders bevorzugt sind die Hin- und Rückleiter der Heizschlaufen bifilar mit möglichst geringem Abstand voneinander angeordnet, um die Ausbildung eines störenden Magnetfelds bei Stromdurchfluß möglichst gering zu halten.

Dazu ist es vorteilhaft, wenn die Hin- und Rückleiter der Heizschlaufen aus zwei übereinander angeordneten länglichen Streifen bestehen, welche durch eine Isolierschicht bzw. einen Isolierstreifen elektrisch voneinander isoliert sind.

Besonders bevorzugt ist eine Weiterbildung, bei der die Hin- und Rückleiter der Heizschlaufen aus Materialien von unterschiedlicher magnetischer Suszeptibilität aufgebaut sind, die so ausgewählt sind, daß die gesamte Heizschlaufe jeweils nach außen magnetisch kompensiert ist, um keine zusätzlichen Magnetfelder bei Stromfluß zu erzeugen, da diese die Auflösung der aufgenommenen NMR-Spektren verschlechtern würden.

Geometrisch kann die Temperiereinrichtung so aufgebaut sein, daß eine oder mehrere Heizschlaufen wendelförming um das Raumtemperaturrohr herum angeordnet sind.

Alternativ können aber auch mehrere, vorzugsweise mindestens 8 Heizschlaufen mit Abstand voneinander in Umfangsrichtung um die z-Achse des Raumtemperaturrohres herum angeordnet sein und sich parallel zur z-Richtung erstrecken.

Vorteilhafterweise sind die Heizschlaufen räumlich so orientiert, daß ihre Kopplung zum HF-Empfangsspulensystem minimal ist.

Besonders bevorzugt ist eine Ausbildung der Heizschlaufen aus einem möglichst gut elektrisch leitenden Material (z.B. Cu), wobei die Leiter rechteckförmige, möglichst quadratische oder kreisrunde Querschnitte haben (typischerweise in der Größenordnung von 10 µm x × 10µm oder kleiner). Durch die sich daraus ergebende sehr kleine Gesamt-Flächenbedeckung bleibt das Raumtemperaturrohr für die HF-Felder sehr gut durchlässig, auch die HF-Verluste werden durch sowohl die kleinen Oberflächen der Heizleiter wie auch durch die gute elektrische (und somit HF)Leitfähigkeit sehr tief gehalten.

Bei einer bevorzugten Weiterbildung der oben geschilderten Ausführungsformen kann zwischen der Stromquelle und den Heizschlaufen ein Tief-Paß-Filter vorgesehen sein, um eine Signalverschleppung sowie die Restdämpfung möglichst niedrig zu halten.

Bevorzugt ist auch eine Weiterbildung, bei der zwischen der Stromquelle und den Heizschlaufen ein Parallel-Schwingkreis vorgesehen ist, dessen Resonanzfrequenz bei der empfindlichsten für die NMR-Messung relevanten HF-Frequenz liegt. Ein solcher Sperrkreis verhindert ebenfalls die Aussendung von Störsignalen an das HF-Empfangsspulensystem und minimiert eine unerwünschte Auskopplung der HF-Signale durch die Heizschlaufen.

Um weitere Störungen des statischen Magnetfeldes möglichst gering zu halten, ist es bei einer Weiterbildung schließlich vorteilhaft, wenn die Stromquelle die Heizschlaufe mit Wechselstrom beschickt.

Dabei sollte beim Heizstrom I_{H} = I₀ . cos ω_{H}t durch die Heizschlaufen die Kreisfrequenz ω_{H} so gewählt werden, daß die entsprechenden Seitenbanden außerhalb des beobachtbaren NMR-Spektrums liegen.

Insbesondere sollte gelten: 1 kHz ≤ ω_{H}/2π ≤ 10 GHz, vorzugsweise 10 kHz ≤ ω_{H}/2π ≤ 1 MHz. Insgesamt ist es von großem Vorteil, wenn die Temperiereinrichtung, insbesondere das Raumtemperaturrohr selbst, eine Heizschicht und/oder Heizschlaufen aus Material hoher termischer Leitfähigkeit aufgebaut sind, weil dann die Heizung besonders gleichmäßig auf der ganzen Oberfläche der entsprechenden Heizeinrichtungen erfolgen kann, was der Ausbildung von Temperaturgradienten im Probenröhrchen entgegenwirkt.

Eine besonders bevorzugte Ausführungsform der erfindungsgemäßen NMR-Probenkopfvorrichtung sieht vor, daß zwischen dem HF-Empfangsspulensystem und dem Raumtemperaturrohr das Raumtemperaturrohr in azimutaler Richtung umgebende, in z-Richtung ausgedehnte Strahlungsschilde angeordnet sind, welche aus einem oder mehreren in z-Richtung ausgerichteten Materialien aufgebaut sind, die für HF-Felder nahezu vollständig transparent sind, zumindest aber eine Absorption < 5%, vorzugsweise <1% für HF-Felder aufweisen.

In der Kryotechnik ist es zwar an sich seit langem bekannt, bei Wärmestrahlungsverlusten Strahlungsschilde einzusetzen, jedoch verbietet sich dieses Vorgehen zunächst im Falle eines gekühlten NMR-Probenkopfes, weil durch die in der Regel metallischen, Wärmestrahlung reflektierenden Strahlungsschilde eine Ausbreitung der HF-Felder von der Meßprobe zu den HF-Empfangsspulen ebenfalls entweder ganz abgeblockt oder zumindest stark behindert wird, so daß die ankommenden NMR-Signale zumindest extrem stark gedämpft, verzerrt oder überhaupt nicht mehr verwertbar wären.

Durch die erfindungsgemäße Lösung werden jedoch für die im Vakuum zwischen den HF-Spulen und dem Raumtemperaturrohr vorgesehenen Strahlungsschilde nur Materialien verwendet, welche einerseits in z-Richtung eine Ausrichtung besitzen. Die axiale Ausrichtung des Materials der Strahlungsschilde verhindert, daß deren endliche Suszeptibilität die Auflösung der NMR-Signale verschlechtert. Andererseits sollen die Materialien von ihren physikalischen Eigenschaften her im Bereich von Hochfrequenz-Strahlung möglichst transparent sein. Meistens muß die letztgenannte Materialeigenschaft aber damit erkauft werden, daß keine allzu hohe Rückreflektion der Verlustwärme zur Meßprobe hin erwartet werden kann.

Vorteilhaft ist es, wenn in radialer Richtung wenigstens ein minimaler Abstand zwischen den Strahlungsschilden voneinander vorhanden ist und sich die Strahlungsschilde nicht oder zumindest nur punktuell bzw. linienförmig berühren, damit keine direkte Wärmeleitung zwischen den einzelnen Strahlungsschilden in radialer Richtung entsteht, die zu einem thermischen "Kurzschluß" führen würde. Allerdings stellt auch ein gelegentliches Berühren der Strahlungsschilde kein ernstliches Problem dar, insbesondere wenn ein Material gewählt wird, welches ohnehin eine sehr niedrige Wärmeleitung aufweist. So lange die einzelnen Berühungspunkte bzw. -linien genügend weit auseinanderliegen, ist die gesamte Wärmeleitung zwischen den radial angeordneten Strahlungsschilden für die erfindungsgemäßen Zwecke im wesentlichen vernachlässigbar.

Besonders bevorzugt ist eine Weiterbildung, bei der die Strahlungsschilde aus Material aufgebaut sind, welches Strahlung in einem Wellenlängenbereich 10µm ≤ λ ≤ 100µm reflektiert oder zumindest absorbiert, und welches für Strahlung in einem Wellenlängenbereich λ > 100mm transparent ist. Der erstgenannte Wellenlängenbereich entspricht Wärmestrahlung auf einer Temperatur zwischen ca. 20 K bis 300 K, was der Temperaturdifferenz zwischen der Meßprobe und den gekühlten NMR-Spulen gleichkommt, während der zweite Wellenlängenbereich einer Strahlung mit einer Frequenz unterhalb von 3 GHz entspricht, wobei der für die NMR-Messungen wichtige HF-Bereich zwischen einigen MHz unter etwa 1GHz liegt.

Ein optimales Material, welches praktisch keine Absorptionsverluste im betrachteten HF-Bereich aufweist, andererseits aber für den obengenannten Wärmestrahlungsbereich nicht transparent ist, ist beispielsweise Glas oder Quarz.

Die Strahlungsschilde des erfindungsgemäßen NMR-Probenkopfes könnten theoretisch als koaxial um das Raumtemperaturrohr herumlaufende Rohre ausgeführt sein. Jedoch dürfte das Rohrmaterial in der Regel eine zu große Dicke aufweisen. Möglich ist auch der Aufbau der Strahlungsschilde aus einer unidirektionalen Folie, deren Herstellung und Verarbeitung allerdings relativ schwierig ist. Die Ausrichtung der Folie längs der z-Achse kann beispielsweise durch Anwendung mechanischer Zugspannung hergestellt werden. Bevorzugt ist demgegenüber eine Ausführungsform, bei der die Strahlungsschilde aus einem unidirektionalen Gewebe aufgebaut sind. Derartige unidirektionale Gewebe aus entsprechend geeigneten Materialien sind ohne weiteres im Handel erhältlich.

Bevorzugt bestehen diese Gewebe aus Fasermatten, insbesondere Glasfasermatten, die aus Fasern mit Durchmessern von weniger als 10µm aufgebaut sind und insgesamt eine Dicke von etwa 30 um aufweisen. Anstelle einer radialen Abfolge von zylindrischen Einzel-Strahlungsschilden kann bei der Verwendung von derartigen Glasfasermatten auch an ein schneckenförmiges Umwickeln des Raumtemperaturrohres auf seiner Vakuumseite in mehreren Lagen gedacht werden.

Bei einer weiteren besonders bevorzugten Ausführungsform sind die Strahlungsschilde aus in z-Richtung ausgerichteten, radial um die Achse des Raumtemperaturrohres angeordneten Stäben oder Fasern, vorzugsweise Glasfasern und/oder Quarzfasern aufgebaut. Derartige Fasern sind mit Durchmessern zwischen 10 und 50 µm im Handel erhältlich. Es gibt allerdings auch Glasfilamente mit Durchmessern von weniger als 5µm, die allerdings schwierig zu verarbeiten sein dürften.

Bei einer vorteilhaften Weiterbildung sind die Strahlungsschilde aus Faserbündeln aufgebaut, die insgesamt dann wieder eine etwas höhere mechanische Stabilität als die Einzelfilamente aufweisen und daher bei ihrer Verarbeitung ähnlich wie Stäbe einfacher zu handhaben sind.

Die Stäbe oder Fasern können bei Ausführungsformen lose im Raum angeordnet und nur an ihren Enden befestigt sein.

Alternativ können die Stäbe oder Fasern aber auch an einem zum Raumtemperaturrohr koaxial angeordneten Trägerrohr, vorzugsweise an der dem HF-Empfangsspulensystem zugewandten Seite des Raumtemperaturrohres selbst befestigt sein.

Bei einer bevorzugten Weiterbildung sind die Stäbe oder Fasern am Trägerrohr bzw. am Raumtemperaturrohr mit einem für HF-Strahlung transparenten Klebstoff befestigt, so daß keine Dämpfung der HF-Strahlung von der Meßprobe zu der HF-Empfangsspule aufgrund der Verklebung erfolgt.

Vorteilhaft ist auch eine Weiterbildung, bei der die Stäbe oder Fasern in Umfangsrichtung um die Achse des Raumtemperaturrohres herum dicht gepackt angeordnet sind, so daß in radialer Richtung kein "optischer Durchblick" besteht. Auf diese Weise bilden die Stäbe oder Fasern jeweils einen in Umfangsrichtung zusammenhängenden Strahlungsschild.

Besonders bevorzugt ist auch eine Ausführungsform des erfindungsgemäßen NMR-Probenkopfes, bei der eine Zentriervorrichtung zur Zentrierung des Probenröhrchens in Meßposition um die Achse des Raumtemperaturrohres vorgesehen ist. Die Quertemperaturgradienten radial zur z-Achse, die beim Betrieb eines gekühlten NMR-Probenkopfes auftreten können, ergeben sich nämlich als Produkt aus dem Wärmeverlust pro Flächeneinheit, dem Reziprokwert des Massenstromes von Temperiergas und einem Symmetriefaktor, welcher einen Versatz oder eine Winkelabweichung der Achse des Probenröhrchens von der z-Achse des Raumtemperaturrohres beinhaltet. Da diese Asymmetrie als Faktor in das gesamte Produkt eingeht, ergeben sich auch bei kleinen Schrägstellungen der Meßprobe innerhalb des Raumtemperaturrohres erhebliche Einflüsse auf den Temperierungsfluß. Daher kann mit der vorgeschlagenen Zentriervorrichtung ein nicht zu vernachlässigender, zusätzlicher Effekt im Sinne einer Verringerung der Temperaturgradienten und einer Verbesserung der Qualität der NMR-Signale bewirkt werden.

Bei einer besonders einfach realisierbaren Weiterbildung umfaßt die Zentriervorrichtung einen oder mehrere zwischen dem Raumtemperaturrohr und dem Probenröhrchen angeordnete symmetrisch um die z-Achse des Raumtemperaturrohres verteilte Abstandhalter.

Diese Abstandhalter können im Bereich des Bodens des Probenröhrchens in dessen Meßposition und/oder im Bereich der Einfüllöffnung des Raumtemperaturrohres an der dem Probenröhrchen zugewandten Seite des Raumtemperaturrohres angebracht sein. Alternativ können sich die Abstandhalter aber auch über die gesamte axiale Länge des HF-Empfangsspulensystems erstrecken.

Vorteilhaft ist auch eine Weiterbildung, bei der die Abstandhalter aus in Richtung der z-Achse ausgedehnten Streifen aus federndem Material bestehen, die an ihrem dem Probengläschen in dessen Meßposition abgewandten Ende starr mit dem Raumtemperaturrohr verbunden sind, und die an ihrem dem Probengläschen in dessen Meßposition zugewandten Ende eine zum Probengläschen hin ausgebauchte Sicke aufweisen, deren freier Schenkel am Raumtemperaturrohr anliegt.

Um die NMR-Messungen nicht zu stören, sollten die Abstandhalter aus einem für die HF-Strahlung transparenten vorzugsweise magnetisch kompensierten Material aufgebaut sein.

Bei einer bevorzugten Weiterbildung bestehen die Abstandhalter aus Blechstreifen mit einer Dicke von etwa 100µm und einer Breite quer zur z-Achse von etwa 0,5mm bis 2mm, vorzugsweise etwa 1mm.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: einen schematischen Vertikalschnitt längs der z-Achse durch einen nicht beanspruchten NMR-Probenkopf im Bereich des HF-Empfangsspulensystems mit Temperiereinrichtung sowie zugehöriger Temperaturverlauf längs der z-Achse;
- Fig. 2: einen schematischen Vertikalschnitt durch einen gekühlten NMR-Probenkopf nach dem Stand der Technik mit zugehörigem Temperaturverlauf in Richtung der z-Achse;
- Fig. 3a: einen schematischen Horizontalschnitt durch eine Anordnung mit asymmetrisch in das Raumtemperaturrohr eingeführtem Probenröhrchen;
- Fig. 3b: die zur Anordnung nach Fig. 3a zugehörige Temperaturverteilung in z-Richtung;
- Fig. 4a: einen schematischen Vertikalschnitt durch ein Raumtemperaturrohr mit asymmetrisch eingeführtem Probenröhrchen und angedeuteten Konvektionsströmungen innerhalb der Meßprobe;
- Fig. 4b: die zugehörigen Temperaturverläufe in Richtung der z-Achse auf der linken und der rechten Seite der Anordnung von Fig. 4a;
- Fig. 5: ein Schema des Temperaturverlaufs des Temperiergases in Richtung der z-Achse bei asymmetrisch in das Raumtemperaturrohr eingeführtem Probenröhrchen und einer gut wärmeleitenden Innenseite des Raumtemperaturrohres im Bereich der HF-Empfangsspulen;
- Fig. 6a: eine schematische Darstellung einer Ausführungsform der Erfindung mit zwei gegenüberliegenden elektrischen Heizschlaufen längs des Raumtemperaturrohres;
- Fig. 6b: wie Fig. 6a, jedoch mit großer von den Heizschlaufen eingeschlossenen Fläche A;
- Fig. 6c: eine Ausführungsform mit spiralig gewendelter Heizschlaufe;
- Fig. 7: eine schematische Darstellung einer Ausführungsform mit 2 dünnen, durch eine Isolationsfolie getrennten Schichten einer Heizschlaufe;
- Fig. 8a: ein Schaltschema für eine Heizschlaufe mit vorgeschalteten Tiefpaß-Filtern;
- Fig. 8b: wie Fig. 8a, jedoch mit vorgeschalteten Sperrkreisen;

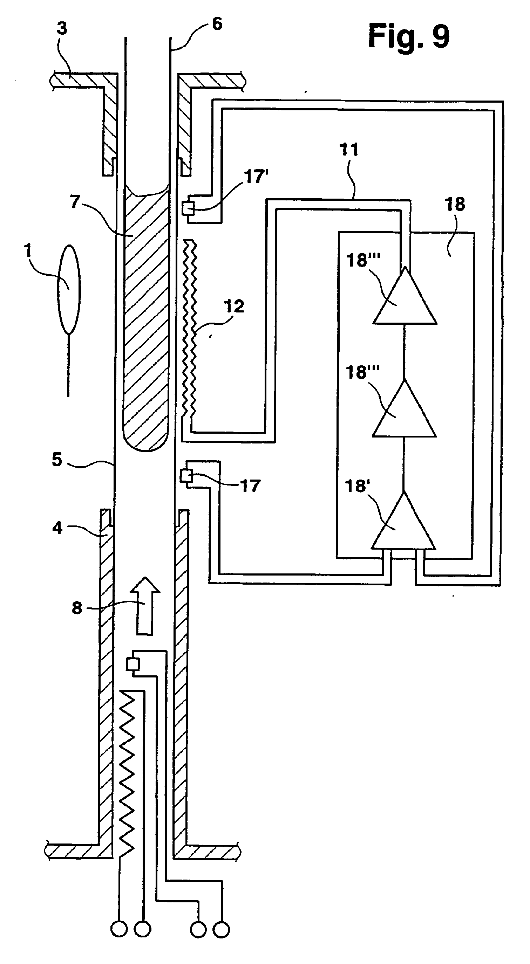

- Fig. 9: einen schematischen Vertikalschnitt durch eine erfindungsgemäße Anordnung mit Heizeinrichtung, Temperaturfühlern und elektronischer Steuerung der Temperierung;
- Fig.10a: einen schematischen Vertikalschnitt durch einen erfindungsgemäßen NMR-Probenkopf mit Wärmeschilden zwischen Raumtemperaturrohr und HF-Empfangsspulensystem;
- Fig.10b: einen schematischen Horizontalschnitt durch eine Anordnung nach Fig. 10a im axialen Bereich des HF-Empfangsspulensystems;
- Fig.11a: einen schematischen Vertikalschnitt durch eine erfindungsgemäße Anordnung mit Zentriervorrichtung; und
- Fig. 11b: einen Horizontalschnitt durch eine Anordnung nach Fig.11a.

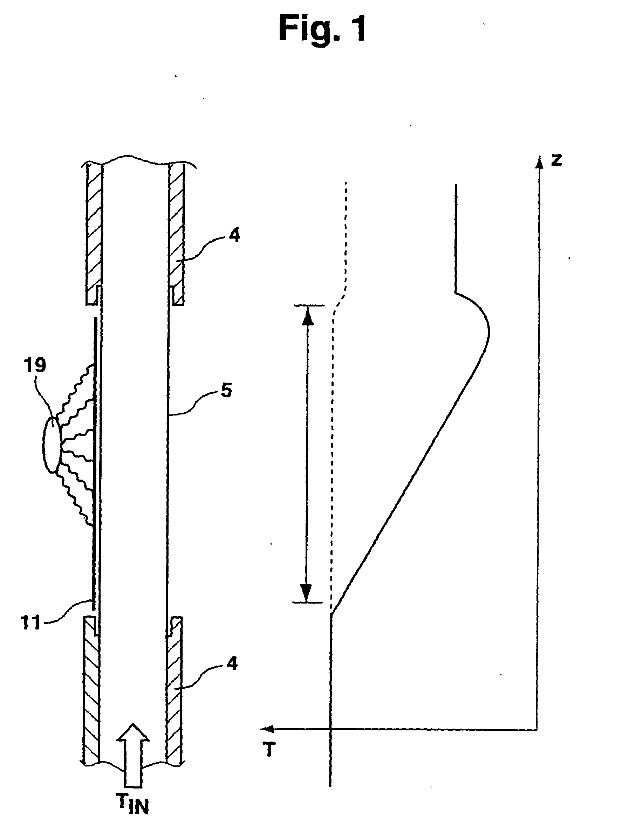

In Fig. 1 ist im schematischen Vertikalquerschnitt ein nicht beanspruchter NMR-Probenkopf mit einer Temperiereinrichtung 11 im axialen Bereich des Innenrohres 5 eines Raumtemperaturrohres 4 sowie der zugehörige Temperaturverlauf längs der z-Achse dargestellt. Die Temperiereinrichtung 11 in Fig. 1 ist durch eine Strahlungsaufheizung einer entsprechenden Fläche am Raumtemperaturrohr 4 im Bereich des Innenrohres 5 mit Hilfe einer Heizeinrichtung 19 realisiert. Diese Ausführungsform ist von den Ansprüchen nicht umfasst.

Erfindungsgemäß umfasst die Temperiereinrichtung 11 eine elektrische Heizung. Der rechts im Bild dargestellte Temperaturverlauf längs der z-Achse zeigt in der durchgezogenen Linie die Situation ohne Temperiereinrichtung und gestrichelt die Situation mit einer geregelten Temperiereinrichtung, wo eine nahezu konstante Temperatur längs der gesamten z-Achse beobachtet werden kann.

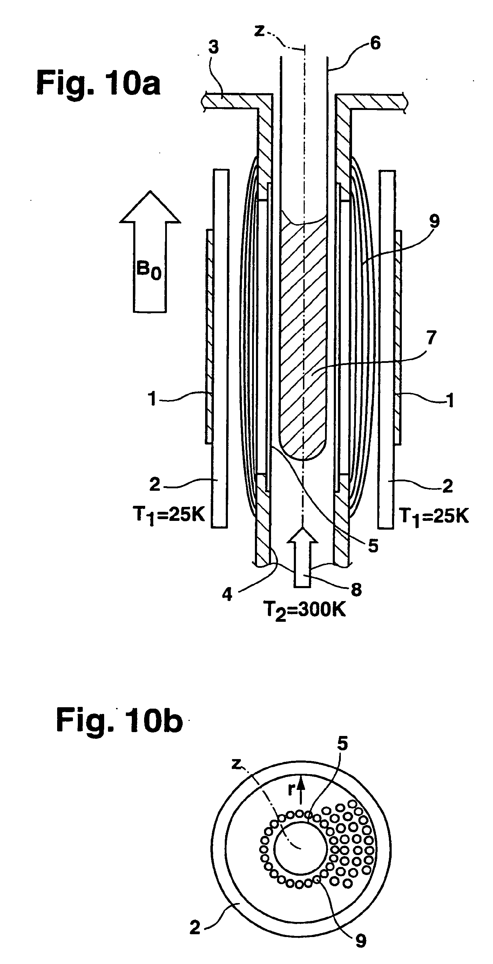

Nähere Einzelheiten des erfindungsgemäßen NMR-Probenkopfes können unter anderem der unten beschriebenen Fig. 10a entnommen werden.

Im folgenden soll die Wirkungsweise der erfindungsgemäßen Anordnung erläutert werden:

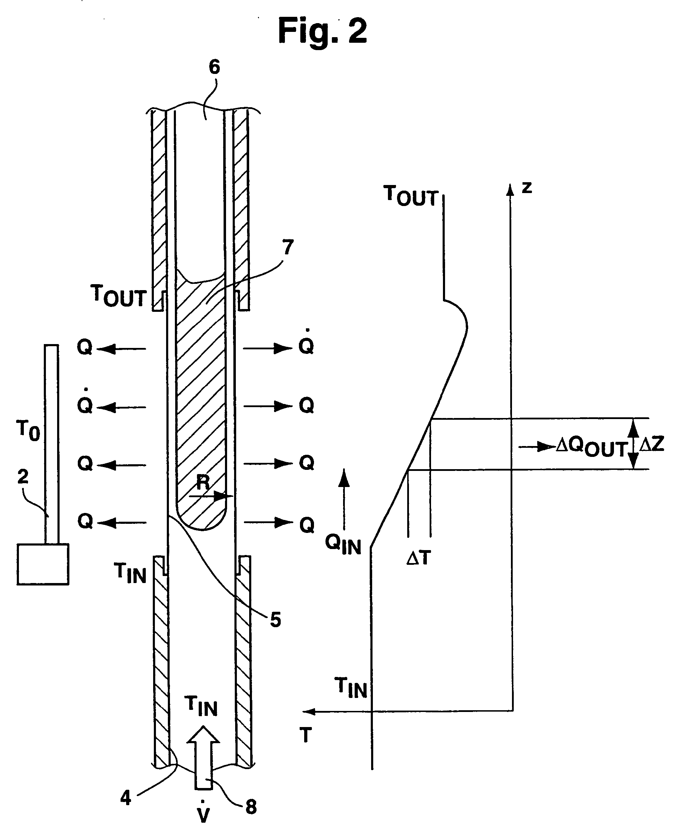

In Fig. 2 ist schematisch ein Ausschnitt aus einem NMR-Probenkopf nach dem Stand der Technik gezeigt, bei den von einem Probenröhrchen 6 radial in Richtung auf das HF-Empfangsspulensystem 1 durch Strahlung Wärmeströme Q abgehen, da das Empfangsspulensystem 1 auf einer kryogenen Temperatur von ungefähr 25 K gehalten wird, während das Probenröhrchen 6 mit Hilfe des von unten her zugeführten temperierten Luftstroms 8 ungefähr auf Zimmertemperatur gehalten werden soll. Durch die Wärmeabstrahlung aus dem Probenröhrchen 6 ergibt sich unter Berücksichtigung der mit dem Temperierstrom 8 zugeführten Wärme ein Temperaturverlauf in axialer Richtung innerhalb des Probenröhrchens 6, wie er auf der rechten Seite von Fig. 2 schematisch gezeigt ist.

Die relativ hohen Temperaturgradienten innerhalb der Probensubstanz 7 führen regelmäßig zu einer unerwünschten Verschlechterung der aufgenommenen NMR-Spektren. Es ergeben sich Linienverbreiterungen aufgrund der Temperaturabhängigkeit der chemischen Verschiebung, was dazu führen kann, daß zwei Substanzen nicht gleichzeitig geshimt werden können. Dieser Effekt ist insbesondere bei Wasser ausgeprägt

Daneben können, wenn der Temperaturgradient einen kritischen Wert überschritten hat, Konvektionseffekte auftreten. Die sich dabei ergebenden Fluktuationen können die Stabilität beim Shimen und bei den NMR-Experimenten erheblich stören.

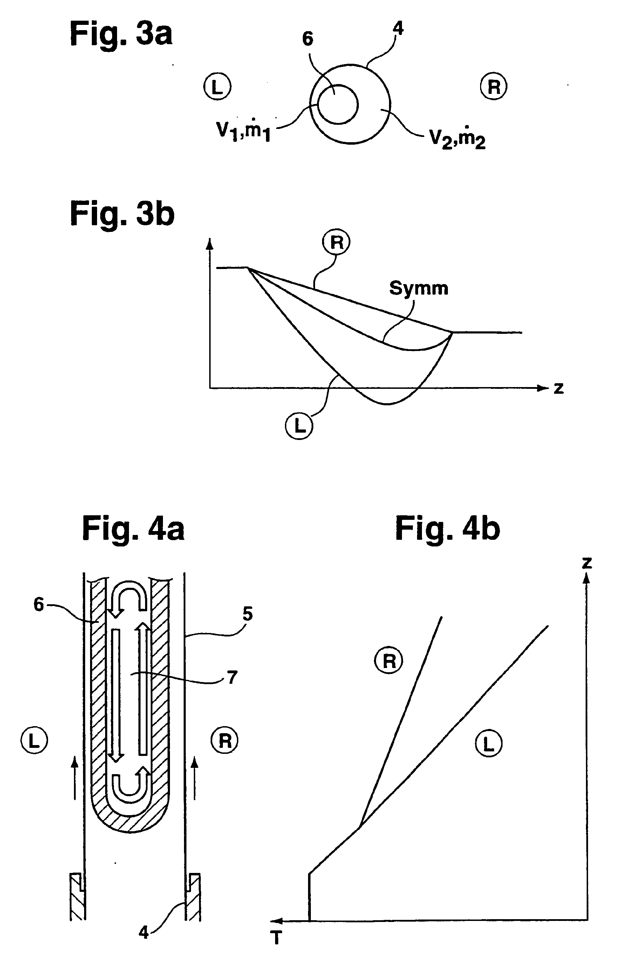

Neben den Temperaturgradienten in z-Richtung können auch transversale Gradienten auftreten, wenn das Probenröhrchen 6 nicht exakt in der Mitte des Raumtemperaturrohres 4 plaziert ist, wie in Fig. 3a in einem Horizontalschnitt schematisch dargestellt.

Durch die unterschiedlichen Massenflüsse, die sich aus den unterschiedlichen Strömungswiderständen auf der linken (L) und der rechten (R) Seite ergeben, treten verschiedene Längsgradienten auf beiden Seiten auf. Dies führt zu einem transversalen Temperaturgradienten, der nach oben hin immer ausgeprägter wird, wie in Fig. 3b dargestellt. Der mittlere der drei gezeigten Temperaturverläufe stellt den symmetrischen Fall dar.

Dieser Gradient begünstigt die Ausbildung einer Konvektion innerhalb der in der Regel flüssigen Probensubstanz 7 zusätzlich. Diese Situation ist in Fig. 4a schematisch dargestellt. Die zugehörigen Temperaturverläufe in z-Richtung sind in Fig. 4b gezeigt. Der Temperaturverlauf auf der rechten Seite (= R) kann dabei ganz erheblich von dem Temperaturverlauf auf der linken Seite (= L) differieren.

Um diesem Effekt entgegenzuwirken, wird der Mittelteil 5 des Raumtemperaturrohres 4 aus gut wärmeleitendem Material ausgeführt. Damit können die transversalen Temperaturgradienten (x-y-Richtung) stark vermindert werden. Es kommen allerdings nur Materialien in Frage, deren Absorption für HF-Strahlung vernachlässigbar gering ist und die gleichzeitig die geforderte hohe Wärmeleitfähigkeit haben. Konkret bietet sich hier Saphir als Material an.

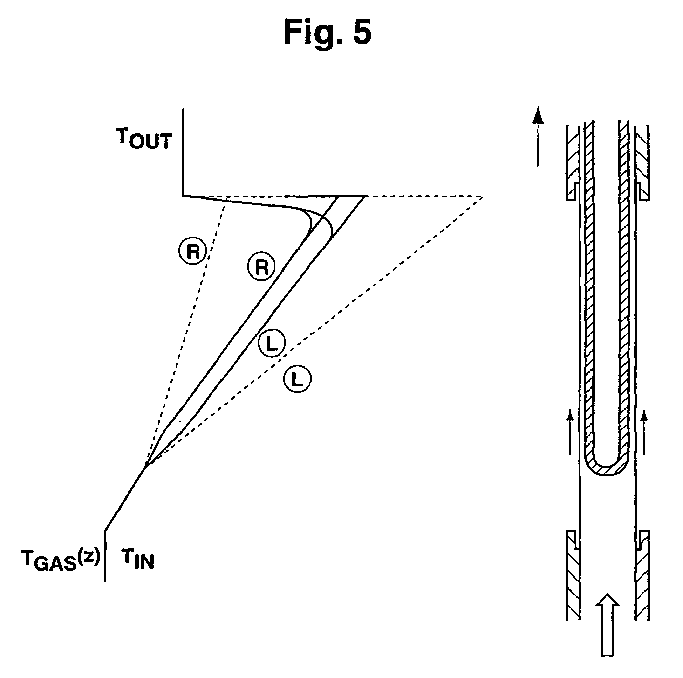

In Fig. 5 ist die Situation ohne gute Wärmeleitung (gestrichelt) und mit guter Wärmeleitung (durchgezogen) des Raumtemperaturrohres 4, insbesondere des Innenrohres 5 dargestellt. Der Temperaturverlauf längs der z-Achse läßt sich (abgesehen von einer Mittelung der beiden Extreme) damit aber praktisch nicht beeinflussen. Lediglich der Temperaturverlauf kurz vor dem oberen Einspannpunkt des Probenröhrchens 6 läßt sich anheben. Ein linearer Temperaturgradient kann durch wärmeleitende Maßnahmen am Raumtemperaturrohr 4 alleine nicht beseitigt werden.

Hier setzt die Erfindung ein, wonach zwischen dem HF-Empfangsspulensystem 1 und dem Probenröhrchen 6 eine das Probenröhrchen in radialer Richtung umgebende, in z-Richtung ausgedehnte Temperiereinrichtung 11 angeordnet ist, welche für HF-Felder nahezu vollständig transparent ist.

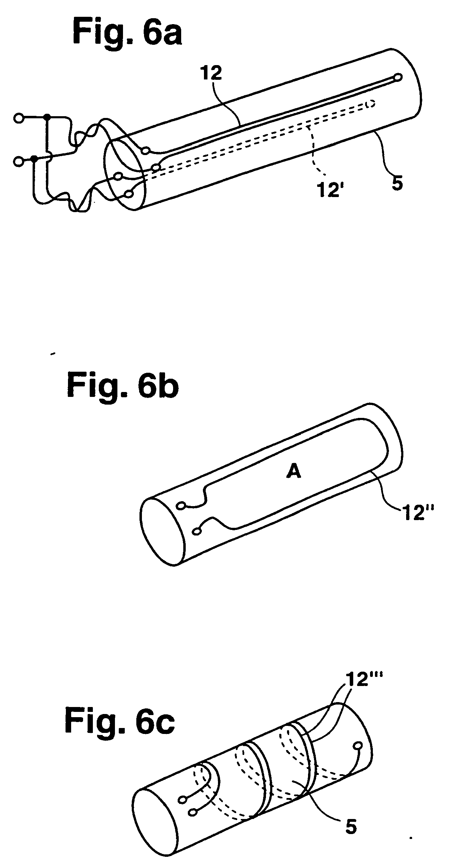

Die Temperiereinrichtung 11 weist elektrisch beheizbare Elemente, insbesondere Heizschlaufen 12, 12' auf, wie sie in Fig. 6a gegenüberliegend und in z-Richtung längs des Innenrohres 5 des Raumtemperaturrohres 4 angeordnet dargestellt sind.

In jedem Falle empfiehlt es sich, das Innenrohr 5 aus Material mit guter Wärmeleitung (beispielsweise Saphir) herzustellen.

In Fig. 6b ist schematisch eine Heizschlaufe 12" dargestellt, die eine relativ große Fläche A umfaßt. Dies sollte in der Praxis vermieden und die Fläche A der Schlaufe minimiert werden, da aufgrund einer zu großen Fläche merkliche Störungen des homogenen Magnetfeldes B₀ in der Meßposition des erfindungsgemäßen NMR-Probenkopfes aufgrund von senkrecht dazu verlaufenden Feldern bei Durchfluß von Strom durch die Heizschlaufen zu befürchten sind.

Fig. 6c zeigt eine erfindungsgemäße Anordnung mit einer wendelförmig um das Innenrohr 5 herumgewickelten Heizschlaufe 12"', bei der wiederum die Fläche zwischen den beiden elektrischen Leitern aus den oben genannten Gründen so gering wie möglich gehalten wurde.

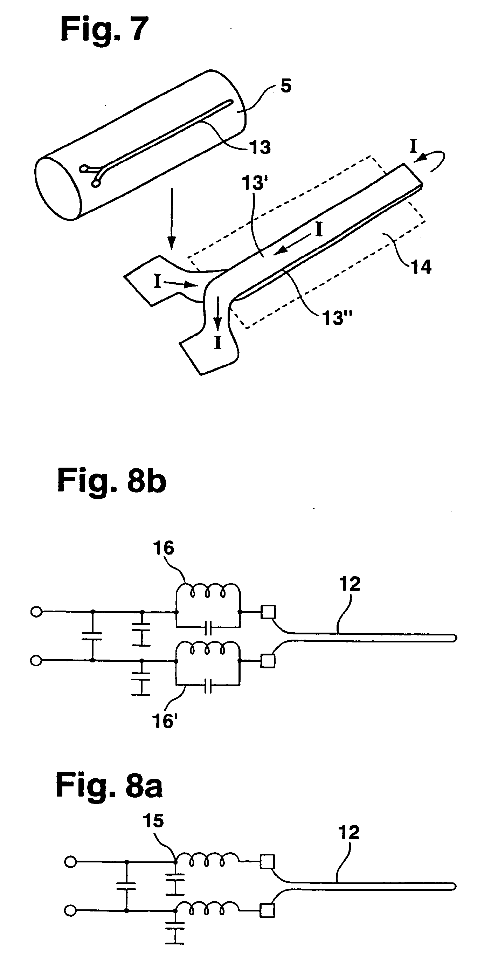

Vorteilhaft kann es bei weiteren Ausführungsformen sein, wenn- wie in Fig. 7 gezeigt - die Heizschlaufe 13 aus zwei dünnen Schichten 13', 13" besteht, welche übereinander angeordnet und durch eine dünne Isolationsfolie 14 elektrisch voneinander getrennt sind. Damit ist die Erzeugung von störenden magnetischen Feldern bei Stromdurchfluß durch die Heizschlaufe 13 praktisch ausgeschlossen.

Als Materialien für die Schichten 13, 13" kommen beispielsweise Kupfer oder Aluminium in Frage, als Material für die Isolierschicht 14 beispielsweise Al₂O₃. Eine solche Anordnung kann aber auch aus einer Kombination von unterschiedlichen Materialien der Schichten 13' und 13" bestehen, wobei diese dann so ausgewählt werden sollten, daß die gesamte Heizschlaufe 13 nach außen hin magnetisch kompensiert ist.

Durch eine geeignete Orientierung der Temperiereinrichtungen 11 zu der empfindlichsten der verwendeten HF-Empfangsspulen kann eine elektromagnetische Kopplung zum HF-Empfangsspulensystem 1 minimiert werden.

Um Signalverschleppungen und Störsignale sowie Restdämpfungen möglichst niedrig zu halten, sollte bei der elektrisch beheizten Variante der erfindungsgemäßen Temperiereinrichtung 11 ein Tiefpaß-Filter 15 vor die entsprechenden Heizschlaufen 12 geschaltet werden, wie in Fig. 8a angedeutet ist.

Eine weiter verbesserte Ausführungsform ist schematisch in Fig. 8b dargestellt, wo vor die beiden Eingänge der Heizschlaufe 12 jeweils ein elektrischer Sperrkreis 16, 16' geschaltet wurde. Dieser sperrt die zu messenden HF-Frequenzen und minimiert zusätzlich den Einfluß des Heizstroms auf die NMR-Messung, wie auch umgekehrt eine Verschleppung und Dämpfung der Meßfrequenzen. Bei Verwendung eines Wechselstromes als Heizstrom durch die Heizschlaufe 12 kann dann die Kreisfrequenz des Wechselstromes so gewählt werden, daß die dadurch erzeugten Seitenbanden außerhalb des beobachtbaren NMR-Spektrums liegen.

Die Heizleistung kann entweder fest, entsprechend dem zu erwartenden radialen Wärmefluß, bei einer Temperatur T_{IN} des von unten her in das Raumtemperaturrohr 4 einströmenden Temperiergases 8 eingestellt und entsprechend der vierten Potenz dieser Temperatur korrigiert werden.

Bei anderen Ausführungen kann aber die Heizleistung auch aktiv reguliert werden. Dazu können zwei Thermometer 17, 17' am unteren und oberen Ende des Innenrohres 5 des Raumtemperaturrohres 4 die dort herrschenden Temperaturen T₁ bzw. T₂ messen und einem elektronischen Regelkreis 18, der die Temperiereinrichtung 11 steuert, zuführen. Im einfachsten Falle kann der Regelkreis 18 aus einem Differenzverstärkter 18' bestehen, der die beiden Temperatursignale der Thermometer 17, 17' empfängt und sein Differenzsignal an einen Regler 18" weitergibt, welcher seinerseits eine Endstufe 18''' ansteuert.

Die in Fig. 10a schematisch dargestellte Ausführungsform der erfindungsgemäßen NMR-Probenkopfvorrichtung weist ein HF-Empfangsspulensystem 1 auf, welches symmetrisch zu einer z-Achse um ein axial verlaufendes Raumtemperaturrohr 4 angeordnet ist, welches zur Aufnahme eines Probenröhrchens 6 dient, das eine Probensubstanz 7 enthält, die mit Hilfe von NMR-Messungen untersucht werden soll.

Das HF-Empfangsspulensystem 1 ist auf Wärmeleitungselementen 2 aufmontiert, die zur Kühlung des HF-Empfangsspulensystems 1 auf kryogene Temperaturen, in der Regel T₁ ≈ 25 K dienen.

Das Raumtemperaturrohr 4 ist in seinem oberen und unteren Abschnitt mit einem Gehäuse 3 des NMR-Probenkopfes verbunden, während es in seinem mittleren Abschnitt ein für HF-Felder durchlässiges Innenrohr 5 (meist aus Glas) aufweist. Das axial in das Raumtemperaturrohr 4 ragende Probenröhrchen 6 wird mittels eines Gasstromes 8, der ungefähr auf Zimmertemperatur T₂ ≈ 300 K temperiert ist, während der Messungen auf der gewünschten Temperatur gehalten.

Wie aus den Figuren 10a und 10b deutlich wird, sind zwischen dem Empfangsspulensystem 1 und dem Raumtemperaturrohr 4 mehrere Strahlungsschilde 9 angeordnet, die das Raumtemperaturrohr 4 in radialer Richtung umgeben und längs der z-Achse ausgedehnt sind. Die Strahlungsschilde 9 sind aus in z-Richtung ausgerichteten Materialien aufgebaut, welche für HF-Felder nahezu vollständig transparent sind. In radialer Richtung sind die Strahlungsschilde 9 voneinander beabstandet und berühren sich nicht oder zumindest nur punktuell bzw. linienförmig, wie in Fig. 10b gut erkennbar ist. Sie weisen eine radiale Dicke < 0,1 mm, vorzugsweise < 50 µm auf. Als bevorzugtes Material für die Strahlungsschilde 9 wird Glas oder Quarz verwendet.

Um die erfindungsgemäß geforderte Ausrichtung des Materials in z-Richtung zu erreichen, können die Strahlungsschilde 9 aus einer unidirektionalen Folie, aus unidirektionalem Gewebe, insbesondere aus Glasfasermatten oder aus axial verlaufenden Stäben oder Fasern, vorzugsweise Glas- oder Quarzfasern oder Faserbündeln aufgebaut sein.

Die Strahlungsschilde 9 können lose im Raum angeordnet und nur an ihren Enden befestigt oder, wie im gezeigten Ausführungsbeispiel am Raumtemperaturrohr 4 befestigt sein.

Der Übersichtlichkeit halber ist in den Figuren 10a, 10b die erfindungsgemäß eingesetzte Temperiereinrichtung nicht gezeigt. Sie kann nach einer der oben beschriebenen Arten realisiert sein.

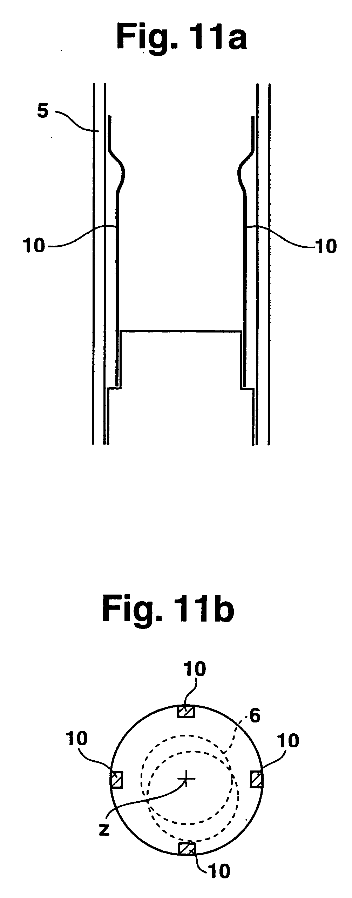

Die Figuren 11a und 11b schließlich zeigen eine bevorzugte Ausführungsform des erfindungsgemäßen NMR-Probenkopfes mit einer Zentriervorrichtung, die im gezeigten Ausführungsbeispiel vier symmetrisch um die z-Achse verteilte Abstandhalter 10 umfaßt. Durch eine damit bewirkte saubere Zentrierung des Probenröhrchens 6 innerhalb des Raumtemperaturrohres 4 können, wie bereits oben erläutert, Konvektionsströme und damit die Bildung von Temperaturgradienten innerhalb der Probensubstanz 7 vermieden werden.

## Patentansprüche

1. NMR-Probenkopfvorrichtung
- mit einem auf kryogene Temperaturen abkühlbaren HF-Empfangsspulensystem (1)
- mit einem in einer z-Richtung verlaufenden Raumtemperaturrohr (4), das im axialen Bereich des Empfangsspulensystems aus einem HF-durchlässigen Innenrohr (5) besteht und das zur Aufnahme eines Probenröhrchens (6) längs der z-Richtung dient, welches mittels NMR-Messung zu untersuchende Probensubstanz (7) enthält,
- sowie mit einer Vorrichtung zur Temperierung eines durch das Raumtemperaturrohr dem Probenröhrchen von unten her zugeführten, ungefähr auf Raumtemperatur gehaltenen Luftstroms (8),
**dadurch gekennzeichnet,**
- **dass** das HF-durchlässige Innenrohr (5) aus Material mit guter Wärmeleitung hergestellt ist,
- **dass** zwischen dem radial ausserhalb des Innenrohrs angeordneten HF-Empfangsspulensystem (1) und dem Innenrohr (5), im axialen Bereich des Empfangsspulensystems, eine das Innenrohr in azimutaler Richtung umgebende, in z-Richtung ausgedehnte Temperiereinrichtung (11) angeordnet ist, welche für HF-Felder eine Absorption kleiner als 5% aufweist,
- wobei die Temperiereinrichtung (11) Heizschlaufen (12,12',12";13) aus dünnem, elektrisch gut leitfähigem Material umfasst, die jeweils einen Hin- und einen Rückleiter aufweisen, die an ihrem einen Ende elektrisch miteinander verbunden sind und am anderen Ende mit Heizstrom aus einer Stromquelle beschickt werden können,
- und wobei entweder mehrere, sich parallel zur z-Achse erstreckende Heizschlaufen (12,12',12";13) mit Abstand voneinander in Umfangsrichtung um das Innenrohr herum angeordnet sind, oder ein oder mehrere Heizschlaufen (12''') das Innenrohr wendelförmig umgeben.

2. NMR-Probenkopfvorrichtung nach Anspruch 1, **dadurch gekennzeichnet, dass** die Hin- und Rückleiter der Heizschlaufen (12, 13) aus Materialien von unterschiedlicher magnetischer Suszeptibilität aufgebaut sind, die so ausgewählt sind, dass die gesamte Heizschlaufe jeweils nach aussen magnetisch kompensiert ist.

3. NMR-Probenkopfvorrichtung nach einem der Ansprüche 1 oder 2, **dadurch gekennzeichnet, dass** die Heizschlaufen (12, 13) räumlich so orientiert sind, dass ihre Kopplung zum HF-Empfangsspulensystem minimal ist.

4. NMR-Probenkopfvorrichtung nach einem der vorhergehenden Ansprüche, **dadurch gekennzeichnet, dass** zwischen der Stromquelle und den Heizschlaufen ein Tiefpassfilter (15) oder ein Parallel-Schwingkreis (16, 16') vorgesehen ist, dessen Resonanzfrequenz bei der empfindlichsten für die NMR-Messung relevanten HF-Frequenz liegt.

5. NMR-Probenkopfvorrichtung nach einem der vorhergehenden Ansprüche, **dadurch gekennzeichnet, dass** zwischen dem HF-Empfangsspulensystem und dem Raumtemperaturrohr (5) mindestens ein, vorzugsweise mehrere das Raumtemperaturrohr in azimutaler Richtung umgebende, in z-Richtung ausgedehnte Strahlungsschilde (9) angeordnet sind, welche aus einem oder mehreren in z-Richtung ausgerichteten Materialien aufgebaut sind, die für HF-Felder nahezu vollständig transparent sind, zumindest aber eine Absorption < 5%, vorzugsweise < 1% für HF-Felder aufweisen.

6. NMR-Probenkopfvorrichtung nach einem der vorhergehenden Ansprüche, **dadurch gekennzeichnet, dass** eine Zentriervorrichtung zur Zentrierung des Probenröhrchens (6) in Messposition um die Achse des Raumtemperaturrohres (4) vorgesehen ist, die einen oder mehrere zwischen dem Raumtemperaturrohr und dem Probenröhrchen angeordnete, symmetrisch um die z-Achse des Raumtemperaturrohres verteilte Abstandshalter (10) umfasst, die im Bereich des Bodens des Probenröhrchens (6) in dessen Messposition und/oder Abstandshalter (10) im Bereich der Einfüllöffnung des Raumtemperaturrohres (4) an der dem Probenröhrchen zugewandten Seite des Raumtemperaturrohres (4) angebracht sind.

## Claims

1. NMR probe head device comprising
- an RF receiver coil system (1) which can be cooled down to cryogenic temperatures,
- a room temperature pipe (4) extending in the z direction and consisting of an RF-permeable inner pipe (5) in the axial region of the receiver coil system and receives a sample tube (6) along the z direction, which contains sample substance (7) to be examined by NMR measurement; and
- a device for tempering an air flow (8) which is kept approximately at room temperature and is supplied from below through the room temperature pipe to the sample tube,
**characterized in that**
- the RF-permeable inner pipe (5) is produced from a material having good thermal conductivity,
- a tempering means (11) surrounding the inner pipe in an azimuthal direction, extending in the z direction and exhibiting an absorption for RF fields of less than 5% is disposed between the RF receiver coil system (1), which is disposed radially outside of the inner pipe, and the inner pipe (5) in the axial region of the receiver coil system;
- wherein the tempering means (11) comprises heating coils (12, 12', 12''; 13) of a thin material having good electrical conducting properties, each comprising an outgoing and a return conductor which are electrically connected to each other at one end, wherein the other end can be supplied with a heating current from a current source, and
- wherein either several heating coils (12, 12', 12''; 13) extending parallel to the z axis are disposed in a peripheral direction around the inner pipe at a separation from each other, or one or more heating coils (12''') helically surround the inner pipe.

2. NMR probe head device according to claim 1, **characterized in that** the outgoing and return conductors of the heating coils (12, 13) are made from materials having different magnetic susceptibility which are selected such that the overall heating coil is magnetically compensated towards the outside.

3. NMR probe head device according to claim 1 or 2, **characterized in that** the heating coils (12, 13) are spatially oriented such that they are minimally coupled to the RF receiver coil system.

4. NMR probe head device according to any one of the preceding claims, **characterized in that** a low-pass filter (15) or a parallel resonant circuit (16, 16') is provided between the current source and the heating coils, which has a resonant frequency at the most sensitive RF frequency relevant for the NMR measurement.

5. NMR probe head device according to any one of the preceding claims, **characterized in that** at least one, preferably a plurality of radiation shields (9), is disposed between the RF receiver coil system and the room temperature pipe (5), which extend in the z direction, surround the room temperature pipe in an azimuthal direction, and are made from one or more materials oriented in the z direction which are almost completely transparent to RF fields or at least exhibit an absorption for RF fields of <5%, preferably <1%.

6. NMR probe head device according to any one of the preceding claims, **characterized in that** a centering device is provided for centering the sample tube (6) in its measuring position about the axis of the room temperature pipe (4), which comprises one or more spacers (10) which are disposed between the room temperature pipe and the sample tube, are distributed symmetrically about the z axis of the room temperature pipe, and are disposed in the area of the bottom of the sample tube (6) in its measuring position and/or spacers (10) in the area of the feed opening of the room temperature pipe (4) on the side of the room temperature pipe (4) facing the sample tube.

## Revendications

1. Tête de mesure RMN
- comprenant un système de bobines de réception HF (1) pouvant être refroidi à des températures cryogéniques
- comprenant un tube à température ambiante (4) s'étendant dans une direction z qui est constitué dans la zone axiale du système de bobines de réception d'un tube intérieur (5) perméable aux HF et qui sert à recevoir un tube à essai ou à échantillon (6) le long de la direction z, lequel contient une substance d'essai ou d'échantillon (7) à analyser au moyen d'une mesure RMN,
- ainsi que comprenant un dispositif pour l'équilibrage de la température d'un courant d'air (8) amené par le bas au tube à essai à travers le tube à température ambiante et maintenu approximativement à température ambiante,
**caractérisée en ce que**
- le tube intérieur (5) perméable aux HF est réalisé dans un matériau à bonne conduction thermique,
- un dispositif d'équilibrage de la température (11) entourant le tube intérieur en direction azimutale, allongé en direction z, est disposé dans la zone axiale du système de bobines de réception entre le système de bobines de réception HF (1) disposé radialement à l'extérieur du tube intérieur et le tube intérieur (5), lequel dispositif d'équilibrage de la température présente une absorption inférieure à 5 % pour les champs HF,
- sachant que le dispositif d'équilibrage de la température (11) comprend des boucles chauffantes (12, 12', 12" ; 13) en matériau mince, bon conducteur de l'électricité, qui présentent chacune un conducteur aller et un conducteur retour qui sont reliés électriquement entre eux à une extrémité et alimentés en courant de chauffage par une source de courant à l'autre extrémité,
- et sachant que soit plusieurs boucles chauffantes (12, 12', 12" ; 13) s'étendant parallèlement à l'axe z à distance l'une de l'autre en direction circonférentielle sont disposées autour du tube intérieur, soit une ou plusieurs boucles chauffantes (12"') entourent le tube intérieur en spirale.

2. Tête de mesure RMN selon la revendication 1, **caractérisée en ce que** les conducteurs aller et retour des boucles chauffantes (12, 13) sont constitués de matériaux de susceptibilité magnétique différente qui sont choisis de manière que la boucle de chauffage totale soit chaque fois compensée magnétiquement vers l'extérieur.

3. Tête de mesure RMN selon l'une des revendications 1 ou 2, **caractérisée en ce que** les boucles chauffantes (12, 13) sont orientées dans l'espace de manière que leur couplage avec le système de bobines de réception HF soit minimal.

4. Tête de mesure RMN selon l'une des revendications précédentes, **caractérisée en ce qu'**il est prévu entre la source de courant et les boucles chauffantes un filtre passe-bas (15) ou un circuit oscillant parallèle (16, 16') dont la fréquence de résonance se situe à la fréquence HF la plus sensible convenant à la mesure RMN.

5. Tête de mesure RMN selon l'une des revendications précédentes, **caractérisée en ce qu'**au moins un, de préférence plusieurs écrans anti-rayonnement (9) entourant le tube à température ambiante en direction azimutale, allongés en direction z sont disposés entre le système de bobines de réception HF et le tube à température ambiante (5), lesquels écrans anti-rayonnement sont constitués d'un ou plusieurs matériaux orientés en direction z qui sont presque complètement transparents aux champs HF mais présentent au moins une absorption < 5 %, de préférence < 1 %, pour les champs HF.

6. Tête de mesure RMN selon l'une des revendications précédentes, **caractérisée en ce qu'**il est prévu un dispositif de centrage pour centrer le tube à essai (6) en position de mesure autour de l'axe du tube à température ambiante (4), qui comprend une ou plusieurs pièces d'écartement (10) disposées entre le tube à température ambiante et le tube à essai, réparties symétriquement autour de l'axe z du tube à température ambiante, qui sont placées au niveau du fond du tube à essai (6) dans sa position de mesure et/ou au niveau de l'ouverture de remplissage du tube à température ambiante (4) du côté du tube à température ambiante (4) tourné vers le tube à essai.
